Europäisches Patentamt

European Patent Office

Office européen des brevets

(11) Publication number: 0 364 132
A1

# EUROPEAN PATENT APPLICATION

(21) Application number: 89309866.5

(22) Date of filing: 28.09.89

(51) Int. Cl.5: **C23F 11/14 , C23C 22/52**

(30) Priority: 29.09.88 JP 247247/88
09.06.89 JP 148136/89

(43) Date of publication of application:
18.04.90 Bulletin 90/16

(84) Designated Contracting States:
DE FR GB IT

(71) Applicant: SHIKOKU CHEMICALS CORPORATION
147-1-Minato-machi Marugame-shi
Kagawa-ken(JP)

(72) Inventor: Matsubara, Susumu
165, Nishihirayama-cho
Marugame-shi Kagawa-shi(JP)
Inventor: Yoshida, Shuji
2-20, Nishihonmachi 2-chome
Marugame-shi Kagawa-ken(JP)
Inventor: Minagawa, Masahiko
6-13, Hamazaki 3-chome
Asaka-shi Saitama-ken(JP)
Inventor: Tachibana, Daikichi
5-20 Hayamiya 2-chome Nerima-ku
Tokyo(JP)
Inventor: Kodama, Hiroki
885-2, Tsunomori-cho
Marugame-shi Kagawa-ken(JP)

(74) Representative: Cresswell, Thomas Anthony
et al
J.A. Kemp & Co. 14 South Square Gray's Inn
London WC1R 5EU(GB)

(54) Method for forming conversion coating on surface of copper or copper alloy.

(57) A process for the formation of a chemical conversion coating on the surface of copper or a copper alloy comprises contacting the metal surface with an aqueous solution containing an imidazole compound having an alkyl group having 5 to 21 carbon atoms at the 2-position, wherein a substance capable of generating a copper ion or zinc ion is dissolved and contained in the aqueous solution containing the alkylimidazole compound.

## EP 0 364 132 A1

# METHOD FOR FORMING CONVERSION COATING ON SURFACE OF COPPER OR COPPER ALLOY

### Background of the Invention

(1) Field of the Invention

The present invention relates to a surface treatment of copper and a copper alloy. More particularly, the present invention provides a method suitable for the rust preventing treatment or preflux treatment of a circuit zone of a printed circuit board or for the formation of an etching resist film.

(2) Description of the Related Art

Processes for forming a coating of an imidazole compound having a long-chain alkyl group at the 2-position on the surface of copper or a copper alloy is disclosed, for example, in Japanese Examined Patent Publication No. 46-17046, No. 48-11454, No. 48-25621, No. 49-1983, No. 49-26183, No. 58-22545 and No. 61-41988, Japanese Unexamined Patent Publication No. 61-90492, and U.S. Patent No. 3,933,531 and No. 4,622,097.

This surface treatment of copper or a copper alloy for forming a coating of an alkylimidazole compound has recently attracted attention as the method for protecting a circuit zone of a printed circuit board.

However, in the conventional surface treatment method, in order to form a conversion coating having a sufficient thickness, it is inevitably necessary to contact the surface of copper with an aqueous solution of an alkylimidazole compound at a relatively high temperature for a long time.

Accordingly, this treatment cannot keep up with elevation of the operation speed in the preparation of a printed circuit board. Moreover, in small-diameter through holes as in a copper through hole printed circuit board, the surface of copper is not precisely treated.

Furthermore, the coating of the alkylimidazole compound formed on the surface of copper or a copper alloy is stable at a temperature close to room temperature, but discoloration is caused in a relatively short time at a high temperature and it is apprehended that soldering on the surface of the formed coating will not be carried out conveniently. Recently, the surface mount technology is often adopted as the means for bonding electronic parts to a printed circuit board. According to this method, several heating operations such as temporary fastening of chip parts, bonding of parts for both surfaces or mixed loading of chip parts and discrete parts are carried out, and therefore, printed circuit boards are kept in more severe heating conditions.

For this reason, in order to obtain a good solderability, it is necessary to improve the heat resistance of the alkylimidazole coating.

### Summary of the Invention

Under this background, we conducted various experiments, and we found that in the formation of a conversion coating on the surface of copper or a copper alloy by contacting the metal surface with an aqueous solution of an imidazole compound having an alkyl group having 5 to 21 carbon atoms at the 2-position, if a substance capable of generating a copper ion is dissolved and contained in the aqueous solution of the alkylimidazole, a conversion coating having a sufficient thickness can be obtained by conducting the contact at a lower temperature for a shorter time than in the case where the aqueous solution not containing a substance capable of generating a copper ion is used. Furthermore, it was found that if a substance capable of generating a zinc ion is dissolved and contained in the aqueous solution of the alkylimidazole compound, a coating having an improved heat resistance can be obtained. We have now completed the present invention based on these findings.

More specifically, in accordance with one fundamental aspect of the present invention, there is provided a method for the formation of a chemical conversion coating on the surface of copper or a copper alloy, which comprises contacting the metal surface with an aqueous solution containing an imidazole compound having an alkyl group having 5 to 21 carbon atoms at the 2-position, wherein a substance capable of

2

generating a copper ion or zinc ion is dissolved and contained in the aqueous solution containing the alkylimidazole compound.

Detailed Description of the Invention

In the method of the present invention, in contacting copper or a copper alloy with an aqueous solution containing an alkylimidazole compound and a copper or zinc ion, the pH value of the aqueous solution should be controlled to 3 to 6, preferably 4 to 5, by adding an acidic substance, preferably an organic acid type compound, into the aqueous solution. If the pH value of the aqueous solution containing the alkylimidazole compound and the metal ion is too large, the complex of the alkylimidazole compound and the metal ion becomes insoluble and precipitated in the solution. In contrast, if the pH value is too small, it is difficult for the alkylimidazole compound to form a complex with the copper or zinc ion on the surface of copper or a copper alloy, and therefore, the speed of the formation of the chemical conversion coating is drastically reduced.

Precipitation of a complex formed by the reaction between the imidazole compound and the copper or zinc ion in the treating aqueous solution should be avoided by adding an acidic substance and ammonia or an amine into the treating aqueous solution.

As typical examples of the alkylimidazole compound that can be used in the present invention, there can be mentioned 2-amylimidazole, 2-heptylimidazole, 2-decylimidazole, 2-undecylimidazole, 2-dodecylimidazole, 2-tridecylimidazole, 2-tetradecylimidazole, 2-heptadecylimidazole, 2-undecyl-4-methylimidazole, 2-heptadecyl-4-methylimidazole, and salts thereof. Among these imidazole compounds, 2-undecylimidazole, 2-undecyl-4-methylimidazole and salts thereof are preferably used.

As typical examples of the substance of capable of generating a copper ion in the treating aqueous solution, that can be used in the present invention, there can be mentioned copper powder, cuprous chloride, cupric chloride, copper hydroxide, copper phosphate, copper acetate, copper sulfate, copper nitrate and copper bromide. Among them, cuprous chloride is especially preferred.

As typical instances of the substance capable of generating a zinc ion in the treating aqueous solution, that can be used in the present invention, there can be mentioned zinc formate, zinc acetate, zinc oxalate, zinc lactate, zinc citrate, zinc benzoate, zinc salicylate, zinc chloride, zinc sulfate, zinc nitrate and zinc phosphate.

Since the alkylimidazole is difficultly soluble in water, in order to sufficiently dissolve the alkylimidazole compound, it is necessary to use a mixed solvent of water and an organic solvent, or to react the alkylimidazole with an organic acid or inorganic acid to convert it to a water-soluble salt.

As the solvent to be used for this purpose, there can be mentioned methanol, ethanol, propanol, ethylene glycol, propylene glycol, cellosolves and acetonitrile.

As the organic acid or inorganic acid to be used for converting the alkylimidazole to a water-soluble salt, there can be mentioned, for example, benzoic acid, acetic acid, formic acid, lactic acid, propionic acid, acrylic acid, stearic acid, palmitic acid, lauric acid, p-nitrobenzoic acid, carylic acid, caproic acid, glycolic acid, succinic acid, p-butylbenzoic acid, maleic acid, tartaric acid, adipic acid, p-toluene-sulfonic acid, picric acid, salicylic acid, m-toluylic acid, oxalic acid, fumaric acid and phosphoric acid.

As the amine to be used for preventing the precipitation of the complex of the metal ion and the alkylimidazole compound in the treating aqueous solution in the method of the present invention, there can be mentioned, for example, methylamine, dimethylamine, ethylamine, monoethanol amine, diethanol amine and triethanol amine.

In carrying out the method of the present invention, it is preferred that ammonia, an amine, an alkali metal hydroxide or carbonate or an alkaline earth metal hydroxide or carbonate be added in advance to the substance capable of generating a copper ion or zinc ion.

For preparing a treating aqueous solution containing an alkylimidazole compound and a copper ion, which is used in the method of the present invention, the alkylimidazole compound is added in an amount of 5 to 50 g per liter of water and the substance capable of generating a copper ion is added in an amount of 0.1 to 5 g per liter of water.

For preparing a treating aqueous solution containing an alkylimidazole and a zinc ion, which is used in the method of the present invention, the alkylimidazole is added in an amount of 0.01 to 5%, preferably 0.1 to 2%, based on water, and the substance capable of generating a zinc ion is added in an amount of 0.02 to 5%, preferably 0.1 to 2%, based on water.

In carrying out the method of the present invention, it is preferred that copper or a copper alloy be mechanically polished or pickled and the metal surface be immersed in the treating aqueous solution or coated or sprayed with the treating aqueous solution.

In the method of the present invention, the surface of copper or the copper alloy is contacted with the treating aqueous solution at a temperature of about 20 to about 60°C for 5 seconds to several minutes.

In the present invention, in the case where a substance capable of generating a copper ion and a substance capable of generating a zinc ion are simultaneously dissolved and contained in the treating aqueous solution containing the alkylimidazole compound, the coating-forming speed is lower than when only the substance capable of generating a copper ion is dissolved in the treating aqueous solution, but the heat resistance of the conversion coating can be improved. However, if a conversion coating having a much improved heat resistance is desired, only the substance capable of generating a zinc ion should be used.

The imidazole compound having a long-chain alkyl group at the 2-position is highly soluble in an acidic aqueous solution, and the dissolved alkylimidazole compound has a high reactivity with copper and an imidazole coating is formed on the surface of copper. It is known that by the action of the hydrogen bond among the long-chain alkylimidazole molecules and the van der Waals force, the alkylimidazole molecules left in the treating aqueous solution are gathered on the surface of the coating and the coating further grows thickly.

In the case where a treating aqueous solution containing an alkylimidazole compound and a substance capable of generating a copper ion or zinc ion is used, the alkylimidazole reacts with the metal ion in the aqueous solution to form a complex and an aggregate of alkylimidazole molecules is formed with the so-formed complex being as the center. This aggregate adheres to the surface of copper in the same manner as described above. It is considered that for this reason, the growth of the conversion coating is expedited.

The mechanism of improving the heat resistance of the coating by the presence of a zinc ion in the treating aqueous solution has not been elucidated in detail, but it is considered that the high ionization tendency of zinc is one cause. Namely, since the ionization tendency of zinc is higher than that of copper, when the surface of copper or a copper alloy is treated with an aqueous solution containing an alkylimidazole compound, an organic acid and a zinc compound, the dissolution of the copper ion into the solution and coating is considerably controlled, and the zinc ion included in the coating on the formation of the coating considerably controls the catalytic action of copper under heating and hence, the heat resistance of the conversion coating is improved.

The present invention will now be described in detail with reference to the following examples and comparative examples that by no means limit the scope of the invention.

In these examples and comparative examples, the thickness of the conversion coating formed on the metal surface was determined in the following manner.

A test piece having a predetermined size was immersed in a 0.5% aqueous solution of hydrochloric acid to elute the alkylimidazole and the concentration of the alkylimidazole in the solution was measured by an ultraviolet spectrophotometer. The thickness of the conversion coating was calculated by the following experimental formula:

Thickness $(\mu)$ = 0.253 x A x y/S

wherein A represents a maximum absorbance at 210 to 220 $m\mu$, S represents the surface area ($cm^2$) of the test piece, and y represents the amount (m$\ell$) of the used aqueous solution of hydrochloric acid.

Example 1

To 20 m$\ell$ of acetic acid was added 10 g of 2-undecyl-4-methylimidazole and they were homogeneously mixed. Separately, 0.4g of cuprous chloride was added to 6 m$\ell$ of 25% aqueous ammonia and the mixture was sufficiently stirred. Both of the solutions were added to 1 $\ell$ of water and the mixture was sufficiently stirred to form a transparent treating solution having a pH value of 4.40.

Then, the copper surface of a copper-clad laminate was polished by using a wet abrasive material ("Scotch Bright" supplied by Sumitomo-3M) and the laminate was immersed in a 1% aqueous solution of hydrochloric acid for 30 seconds, washed sufficiently with water and dried to obtain a test piece. When the obtained test piece was immersed in the above-mentioned treating solution at a liquid temperature of 30°C for 10 seconds, washed with water and dried, a conversion coating having a thickness of 0.3 $\mu$ was formed. When the test piece was allowed to stand still in a thermostat tank maintained at a temperature of 55°C and a relative humidity of 95% for 500 hours, no corrosion was found on the copper surface.

The test piece composed of the copper foil-covered laminate was coated with a postflux ("Soldox FR207" supplied by Toppy Fastener) and immersed in a solder bath at 255°C for 2 seconds. The copper surface showed a good solder stability.

4

Comparative Example 1

To 1 ℓ of water were added 10 g of 2-undecyl-4-methylimidazole and 20 mℓ of acetic acid and the mixture was sufficiently stirred to form a treating solution having a pH value of 4.70. The treatment was carried out by using this treating solution in the same manner as described in Example 1. The thickness of the conversion coating formed on the test piece was 0.1 μ.

When this test piece was allowed to stand still in a thermostat tank maintained at a temperature of 55°C and a relative humidity of 95% for 500 hours, pitting was locally caused on the test piece.

Example 2

To 20 mℓ of propionic acid was added 10 g of 2-undecylimidazole and they were homogeneously mixed. 0.4g of cuprous chloride and 1.2g of triethanol amine were added to 5 mℓ of 25% aqueous ammonia and the mixture was sufficiently stirred. Both solutions were added to 1 ℓ of water and the mixture was sufficiently stirred to obtain a transparent treating solution having a pH value of 4.45.

A test piece composed of a copper foil-covered laminate treated in the same manner as described in Example 1 was immersed in the above-mentioned treating solution at a liquid temperature of 30°C for 10 seconds, washed with water and dried. The thickness of the coating formed on the test piece was 0.35 μ. When the test piece was allowed to stand still in a thermostat tank maintained at a temperature of 55°C and a relative humidity of 95% for 500 hours, no corrosion was found on the copper surface. When the solder wettability of the copper surface. When the solder wettability of the copper surface was examined in the same manner as described in Example 1. Good results were obtained.

For comparison, 10 g of 2-undecylimidazole and 20 mℓ of propionic acid were added to 1 ℓ of water and the mixture was sufficiently stirred to form a treating solution having a pH value of 4.45. The same test piece as described above was immersed in the obtained treating solution at a liquid temperature of 30°C for 10 seconds, washed with water and dried. The thickness of the chemical conversion coating formed on the test piece was 0.05 μ. When the moisture resistance test was carried out in the same manner as described above, local rusting was caused on the surface of the test piece.

Example 3

In 100 mℓ of ethanol were sufficiently stirred 10 g of 2-undecyl-4-methylimidazole and 2.0g of cuprous chloride to completely dissolve cuprous chloride. Then, 7.7 mℓ of acetic acid and 300 mℓ of water were added to the solution and the mixture was sufficiently stirred to prepare a transparent treating solution having a pH value of 4.35.

A test piece composed of a copper foil-covered laminate treated in the same manner as described in Example 1 was immersed in the above-mentioned treating solution at a liquid temperature of 30°C for 10 seconds, washed with water and dried. The thickness of the conversion coating formed on the test piece was 0.4 μ. The test piece was allowed to stand still in a thermostat tank maintained at a temperature of 55°C and a relative humidity of 95% for 500 hours. No corrosion was found on the copper surface. When the solder wettability of the copper surface was examined in the same manner as described in Example 1, good results were obtained.

For comparison, 10 g of 2-undecyl-4-methylimidazole was added to a mixed solvent of 100 mℓ of ethanol and 300 mℓ of water, and the mixture was sufficiently stirred to completely dissolve 2-undecyl-4-methylimidazole. Acetic acid was added to the solution to form a transparent treating solution having a pH value of 4.35. The same test piece as described above was immersed in the treating solution at a liquid temperature of 30° 6 for 10 seconds, washed with water and dried. The thickness of the chemical conversion coating formed on the test piece was 0.13 μ. When the moisture resistance test was carried out in the same manner as described above, rusting was locally caused on the copper surface of the test piece.

Example 4

To 20 mℓ of acetic acid were added 5 g of 2-undecylimidazole and 5g of 2-undecyl-4-methylimidazole and they were sufficiently mixed. Separately, 0.2g of copper powder was added to 5 mℓ of 25% aqueous ammonia and the mixture was sufficiently stirred. Both of the solutions were added to 1 ℓ of water and the mixture was sufficiently stirred to form a transparent treating solution having a pH value of 4.48.

A test piece composed of a copper foil-covered laminate treated in the same manner as described in Example 1 was immersed in the treating solution at a liquid temperature of 30° 6 for 10 seconds, washed with water and dried. The thickness of the formed conversion coating was 0.38 μ. The test piece was allowed to stand still in a thermostat tank maintained at a temperature of 55° C and a relative humidity of 95% for 500 hours. No corrosion was found on the copper surface. When the solder wettability of the copper surface was examined in the same manner as described in Example 1, good results were obtained.

For comparison, 5g of 2-undecylimidazole and 5 g of 2-undecyl-4-methylimidazole were added to 1 ℓ of water, and glycolic acid was added to the mixture with stirring to form a transparent treating solution having a pH value of 4.48. The same test piece as described above was immersed in the treating solution at a liquid temperature of 30 °C for 10 seconds, washed with water and dried. The thickness of the conversion coating formed on the test piece was 0.1 μ. When the moisture resistance test was carried out in the same manner as described above, rusting was locally caused on the surface of the test piece.

## Example 5

To 22.2 m ℓ of acetic acid were added 8g of 2-undecylimidazole and 2g of 2-heptadecylimidazole, and they were homogeneously mixed. 1.0g of cupric chloride was added to 12 m ℓ of 25% aqueous ammonia and the mixture was sufficiently stirred. Both solutions were added to 1 ℓ of water and the mixture was sufficiently stirred to form a treating solution having a pH value of 4.74.

A test piece composed of a copper foil-covered laminte treated in the same manner as described in Example 1 was immersed in the above-mentioned treating solution at a liquid temperature of 30° C for 10 seconds, washed with water and dried. The thickness of the coating formed on the test piece was 0.3 μ. When the test piece was allowed to stand still in a thermostat tank maintained at a temperature of 55° C and a relative humidity of 95% for 500 hours, no corrosion was found on the copper surface. When the solder wettability was examined in the same manner as described in Example 1, good results were obtained.

For comparison, 8g of 2-undecylimidazole and 2g of 2-heptadecylimidazole were added to 1 ℓ of water, and acetic acid was added to the mixture with stirring to form a treating solution having a pH value of 4.74. The same test piece as described above was immersed in the treating solution at a liquid temperature of 30° C for 10 seconds, washed with water and dried. The thickness of the conversion coating formed on the test piece was 0.05 μ. When the moisture resistance test was carried out in the same manner as described above, rusting was locally caused on the surface of the test piece.

## Example 6

To 16.5 m ℓ of formic acid were added 7 g of 2-undecyl-4-methylimidazole and 3g of 2-heptadecyl-4-methylimidazole, and they were homogeneously mixed. Separately, 0.55 g of cupric chloride was added to 4.6 m ℓ of 25% aqueous ammonia and the mixture was sufficiently stirred. Both of the solutions were added to 1 ℓ of water and the mixture was sufficiently stirred to form a treating solution having a pH value of 4.74.

A test piece composed of a copper foil-covered laminate treated in the same manner as described in Example 1 was immersed in the above-mentioned treating solution at a liquid temperature of 30° C for 10 seconds, washed with water and dried. The thickness of the coating formed on the test piece was 0.28 μ. The test piece was allowed to stand still in a thermostat tank maintained at a temperature of 55° C and a relative humidity of 95% for 5 hours. No corrosion was found on the copper surface. When the solder wettability was examined in the same manner as described in Example 1, good results were obtained.

For comparison, 7g of 2-undecyl-4-methylimidazole and 3g of 2-heptadecyl-4-methylimidazole were added to 1 ℓ of water, and formic acid was added to the mixture with stirring to form a treating solution having a pH value of 4.74. The same test piece as described above was immersed in the treating solution at a liquid temperature of 30° C for 10 seconds. The thickness of the coating formed on the test piece was 0.08 μ. When the moisture resistance test was carried out in the same manner as described above, pitting was found here and there on the surface of the test piece.

## Example 7

A test piece composed of a brass plate subjected to the same washing treatment as described in Example 1 by using the treating solution formed in Example 1 was immersed in the treating solution at a liquid temperature of 30°C for 10 seconds, washed with water and dried. The thickness of the conversion coating formed on the test piece was 0.2 μ. When the test piece was allowed to stand still in a thermostat tank maintained at a temperature of 55°C and a relative humidity of 95% for 500 hours, no corrosion was found on the brass surface.

Example 8

To an appropriate amount of water were added 10 g of 2-undecyl-4-methylimidazole and an equimolar amount (2.5 g) of acetic acid to form an aqueous solution containing 2-undecyl-4-methylimidazole acetate. 0.4g of copper sulfate was added to 10 mℓ of water. Both solutions were added to water so that the total volume was 1 ℓ. Then, triethanolamine was added to the mixture with stirring to form a treating solution having a pH value of 4.9.

Then, a test piece composed of a copper foil-covered laminate treated in the same manner as described in Example 1 was immersed in the above-mentioned treating solution at a liquid temperature of 30°C for 10 seconds, washed with water and dried. The thickness of the coating formed on the test piece was 0.3 μ. When the test piece was allowed to stand still in a thermostat tank maintained at a temperature of 55 °C and a relative humidity of 95% for 500 hours, no corrosion was found on the copper surface. When the solder wettability of the copper surface was examined in the same manner as described in Example 1, good results were obtained.

Example 9

Small holes were formed through a glass/epoxy laminate having both the surfaces covered with a copper foil and having a thickness of 1.6 mm (FR-4 R-1705 supplied by Matsushita Denko), and electroless copper plating was carried out and electrolytic plating was then carried out to form a copper plating layer having a thickness of 25 to 30 μ in the interiors of the small holes and on both the surfaces of the laminate.

A resist ink composed mainly of an alkali-soluble rosin-modified phenolic resin (KM-10 supplied by Taiyo Ink) was screen-printed on the laminate to form a negative pattern coating having a thickness of about 20 μ, and the coated laminate was dried at 80°C for 10 minutes.

Then, the above-mentioned substrate was immersed in a 5% aqueous solution of hydrochloric acid and washed with water to clean the surface. Then, the substrate was immersed in the treating solution prepared in Example 1 at a liquid temperature of 50°C for 60 seconds.

The substrate was taken out from the treating solution, washed with water and dried at 120°C for 10 minutes. When the thickness of the alkylimidazole coating of the substrate was measured, it was found that the thickness was 3.5 μ on the average.

Then, the substrate was immersed in a 2% aqueous solution of sodium hydroxide to remove the resist ink by elution and to expose copper in the portion not necessary to be left (negative pattern portion). An alkaline etchant of the ammonia-ammonium chloride-copper system (A Process supplied by Meltex) was sprayed for 120 seconds on the substrate at a temperature of 50°C to effect etching. Then, the substrate was immersed in a 5% aqueous solution of hydrochloric acid to remove the etched resist film on the circuit by elution, whereby a copper through hole printed circuit board was prepared.

The fraction defective in the so-prepared copper through hole printed circuit board was lower than 1%.

For comparison, 10 g of 2-undecyl-4-methylimidazole and 4.5 mℓ of acetic acid were added to 1 ℓ of water to form a treating solution, and the same copper foil-covered laminate as described above was treated with the above-mentioned treating solution under the same conditions as described above to form a copper through hole printed circuit board. When the thickness of the alkylimidazole coating of the substrate was measured, it was found that the thickness was 0.8 μ on the average. Many defects were found in the through holes or circuits, and the fraction defective in the product was 70%.

Example 10 and Comparative Example 2

To 1.0g of 2-undecyl-4-methylimidazole was added 0.40 mℓ of acetic acid, and the imidazole was dissolved. Then, 100 mℓ of pure water was added to the solution, and the mixture was sufficiently stirred to

EP 0 364 132 A1

form a homogeneous solution having a pH value of 4.75. Then, 0.34 g of zinc acetate dihydrate was added to the solution and the mixture was stirred to form a treating solution.

Then, the copper surface of a copper foil-covered laminate having a size of 4 cm x 4 cm was polished by a wet abrasive material ("Scotch Bright" supplied by Sumitomo-3M), immersed in a 0.5% aqueous solution of hydrochloric acid for 15 seconds, washed sufficiently with water and dried to form a test piece. The test piece was immesed in the above-mentioned treating solution under shaking at a liquid temperature of $50°C$ for 1 minute, washed with water and dried. The thickness of the conversion coating formed on the test piece was 0.65 $\mu$. The test piece was allowed to stand still for a predetermined time in a circulation type drier at 150 or $210°C$, whereby the heat treatment was effected.

The solder expansion ratio in the heat-treated test piece was measured according to the method of JIS Z-3197 by using a eutectic solder.

The obtained results were shown in Table 1. Incidentally, at the test, a solution containing 20 g/d$\ell$ of w/w rosin in isopropyl alcohol was used as the postflux. The measurement was carried out 5 times and the mean value was calculated.

For comparison, 0.40 m$\ell$ of acetic acid was added to 1.0g of 2-undecyl-4methylimidazole and the imidazole was dissolved, and 100 m$\ell$ of pure water was added to the solution and the mixture was sufficiently stirred to form a treating solution having a pH value of 4.75. The treatment was carried out by using this treating solution under the same conditions as described in Example 10. The thickness of the chemical conversion coating on the surface of the test piece was 0.60 $\mu$. The solder spread factor after the heat treatment was measured. The obtained results are shown in Table 1.

Table 1

| Solder Spread Factor after Heating | | | |
|---|---|---|---|
| Temperature | Time | Example 10 | Comparative Example 2 |
| $150°C$ | 0 hour | 87.1 % | 86.0 % |
| | 2 hours | 83.2 % | 81.1 % |
| | 3 hours | 81.4 % | 78.0 % |
| | 4 hours | 75.6 % | 60.3 % |
| | 5 hours | 66.8 % | 47.4 % |
| $210°C$ | 5 minutes | 84.2 % | 84.2 % |
| | 10 minutes | 84.2 % | 79.3 % |
| | 15 minutes | 70.4 % | 39.9 % |
| | 20 minutes | 50.6 % | 29.3 % |

Example 11

To 1.0g of 2-undecyl-4-methylimidazole was added 0.57 g of lactic acid and the imidazole was dissolved, and 100 m$\ell$ of pure water was added to the solution and the mixture was sufficiently stirred to form a homogeneous solution having a pH value of 4.62. Then, 0.91 g of zinc lactate was added to and dissolved in the solution with stirring to form a treating solution.

The subsequent operation was carried out in the same manner as described in Example 10. The thickness of the chemical conversion coating was 0.55 $\mu$ and the solder expansion ratio was 80.9% after heating at $150°C$ for 3 hours, 67.2% after heatng at $150°C$ for 5 hours and 51.0% after heating at $210°C$ for 20 minutes. Namely, the obtained results were similar to those obtained in Example 10.

Example 12

To 1.0g of 2-undecylimidazole was added 0.29 g of formic acid and the imidazole was dissolved, and 100 m$\ell$ of pure water was added to the solution and the mixture was sufficiently stirred to form a homogeneous solution having a pH value of 4.60. Then, 0.29 g, 0.59 g or 0.88 g of zinc formate was added

8

to the so-formed solution and dissolved therein with stirring, whereby three kinds of treating solutions were prepared.

The same test piece as used in Example 10 was pre-treated in the same manner as described in Example 10, immersed in the treating solution at a liquid temperature of 50°C for 30 seconds and heat-treated on a solder bath at 250°C for 4 minutes, and the solder expansion ratio was measured by using a solution containing 20 g/dℓ of w/w rosin in isopropyl alcohol as the postflux. It was found that the solder spread factor was 65.3% when 0.29 g of zinc formate was added, 73.8% when 0.59 g of zinc formate was added, and 70.0% when 0.88 g of zinc formate was added.

Comparative Example 3

To 1.0g of 2-undecylimidazole was added 0.29 g of formic acid and the imidazole was dissolved, and 100 mℓ of pure water was added to the solution and the mixture was sufficiently stirred to form a treating solution having a pH value of 4.60. In the same manner as described in Example 12, the coating was formed, the heat treatment was carried out and the solder spread factor was measured. It was found that the solder spread factor was 33.8%.

Example 13

To 1.5g of 2-undecylimidazole was added 0.92 g of lactic acid and the imidazole was dissolved, and 100 mℓ of pure water was added to the solution and the mixture was sufficiently stirred to form a homogeneous solution having a pH vaue of 4.65. Then, 0.34 g of zinc acetate dihydrate was added to the solution and the mixture was stirred to form a treating solution.

Separately, the surface of deoxidized copper (JIS C-122) having a size of 10 mm x 50 mm x 0.3 mm was polished by a wet abrasive material (Scotch Bright supplied by Sumitomo-3M), degreased with ethanol, immersed in a 0.5% aqueous solution of hydrochloric acid for 15 seconds, washed with water and dried to obtain a test piece. The test piece was immersed in the above-mentioned treating solution at a liquid temperature of 50°C for 30 seconds and heat-treated in a circulation type drier at 150°C for 90 minutes.

After the heat treatment, the time of from the point of the start of the immersion to the point when the buoyancy by the surface tension was reduced to zero was measured by using a solder wettability tester (WET- 3000 supplied by RHESCA).

Incidentally, the test piece was immersed in a postflux (JS-64MS-1 supplied by Koki), the liquid was sufficiently removed by using a filter paper, and then, the measurement was carried out. The measurement was started at an immersion depth of 2 mm, and the immersion speed was adjusted to 12 mm/sec. The wetting time was 1.90 seconds.

Comparative Example 4

To 1.5g of 2-undecylimidazole was added 0.92 g of lactic acid and the imidazole was dissolved, and 100 mℓ of pure water was added to the solution and the mixture was sufficiently stirred to form a treating solution having a pH value of 4.65. In the same manner as described in Example 13, a coating was formed, the heat treatment was carried out and the wetting time was measured by using the solder wettability tester. It was found that the wetting time was 3.30 seconds.

Example 14

To 2.0g of 2-undecylimidazole was added 1.30 g of acrylic acid and the imidazole was dissolved, and 100 mℓ of pure water was added to the solution and the mixture was sufficiently stirred to form a homogeneous solution having a pH value of 4.31. Then, 1.0g of zinc acetate dihydrate was added to the solution and the mixture was sufficiently stirred to form a treating solution.

Then, the treatment was carried out in the same manner as described in Example 13 except that a postflux (GX-7 supplied by Asahi Chemical Research Laboratory Limited) was used. When the wettability was determined in the same manner as described in Example 13, it was found that the wetting time was 0.80 second.

9

Comparative Example 5

To 2.0g of 2-undecylimidazole was added 1.30 g of acrylic acid and the imidazole was dissolved, and 100 ml of pure water was added to the solution and the mixture was sufficiently stirred to form a treating solution having a pH value of 4.31.

In the same manner as described in Example 14, a coating was formed and the heat treatment was carried out, and the wetting time was measured by the solder wettability tester. It was found that the wetting time was 1.52 seconds.

As is apparent from the foregoing illustration, when a coating of an imidazole compound is formed on the surface of copper or a copper alloy according to the method of the present invention, the time of the contact between the metal and the treating solution can be shortened to 1/3 or less of the contact time required in the conventional method, and the productivity at the rust-preventing treatment of a circuit zone of a printed circuit board or at the step of forming an etching resist film can be greatly increased.

Furthermore, according to the method of the present invention, a conversion coating having an excellent heat resistance can be formed, and after the heating step in the surface packaging of a printed circuit board, an improved solderability can be imparted.

## Claims

1. A process for producing a chemical conversion coating on the surface of copper or a copper alloy, which comprises contacting the metal surface with an aqueous solution of a substance capable of generating a copper ion or zinc ion and further containing an imidazole compound having a $C_{5-21}$ alkyl at the 2-position.

2. A process according to claim 1, wherein the alkylimidazole compound is 2-undecylimidazole.

3. A process according to claim 1, wherein the alkylimidazole compound is 2-undecyl-4-methylimidazole.

4. A process according to any one of claims 1 to 3, wherein an acidic substance is added to the aqueous solution to adjust the pH value of the aqueous solution to 3 to 6.

5. A process according to any one of claims 1 to 4 which comprises contacting the metal surface with an aqueous solution containing the alkylimidazole compound, an organic acid and a substance capable of generating a copper ion.

6. A process according to claim 5 wherein the aqueous solution contains a copper compound and ammonia or an amine and has a pH value adjusted to 4 to 5.

7. A process according to claim 6 wherein the aqueous solution contains 2-undecylimidazole, an organic acid, cuprous chloride and ammonia.

8. A process according to claim 6 wherein the aqueous solution contains 2-undecyl-4-methylimidazole, an organic acid, cuprous chloride and ammonia.

9. A process according to any one of claims 1 to 4 which comprises contacting the metal surface with an aqueous solution containing the alkylimidazole compound, an organic acid and a substance capable of generating a zinc ion.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | US-A-3 933 531  (N. SAWA) <br> * Claims 1-3,8,10,12,13; column 3, lines 5-13 * | 1-9 | C 23 F  11/14 <br> C 23 C  22/52 |
| A | EP-A-0 170 414  (HITACHI CHEMICAL CO.) <br> * Claims 1-6 * | 1 | |
| A | US-A-4 731 128  (F.J. CASULLO) | | |

|  | TECHNICAL FIELDS SEARCHED (Int. Cl.5) |
|---|---|
|  | C 23 F  11/00 <br> C 23 C  22/00 |

The present search report has been drawn up for all claims

| Place of search | Date of completion of the search | Examiner |
|---|---|---|
| THE HAGUE | 11-01-1990 | TORFS F.M.G. |

EPO FORM 1503 03.82 (P0401)